Europäisches Patentamt

European Patent Office

Office européen des brevets

(19)

(11) **EP 1 020 032 B1**

## (12) FASCICULE DE BREVET EUROPEEN

(45) Date de publication et mention
de la délivrance du brevet:
**30.01.2002 Bulletin 2002/05**

(21) Numéro de dépôt: **98946529.9**

(22) Date de dépôt: **29.09.1998**

(51) Int Cl.⁷: $H03K\ 23/66$, $H03K\ 23/54$

(86) Numéro de dépôt international:
**PCT/FR98/02088**

(87) Numéro de publication internationale:
**WO 99/18669 (15.04.1999 Gazette 1999/15)**

(54) **DIVISEUR DE FREQUENCE A MODULO VARIABLE**

FREQUENZTEILER MIT VARIABLEM MODULUS

FREQUENCY DIVIDER WITH VARIABLE MODULUS

(84) Etats contractants désignés:
**BE DE FR GB**

(30) Priorité: **03.10.1997 FR 9712344**

(43) Date de publication de la demande:
**19.07.2000 Bulletin 2000/29**

(73) Titulaire: **THOMSON CSF**
**75008 Paris (FR)**

(72) Inventeurs:
- **LA ROSA, Jean-Pierre,**
  **Thomson-CSF Prop. Intellect.**
  **F-94117 Arcueil Cedex (FR)**
- **ROULLET, André, Thomson-CSF Prop. Intellect.**
  **F-94117 Arcueil Cedex (FR)**

(74) Mandataire: **Chaverneff, Vladimir et al**
**Thomson-CSF Propriété Intellectuelle, 13,**
**Avenue du Président Salvador Allende**
**94117 Arcueil Cédex (FR)**

(56) Documents cités:
**US-A- 4 648 103**

- **PATENT ABSTRACTS OF JAPAN vol. 012, no.**
  **469 (E-691), 8 décembre 1988 & JP 63 190424 A**
  **(HITACHI LTD), 8 août 1988**
- **PATENT ABSTRACTS OF JAPAN vol. 009, no.**
  **075 (E-306), 4 avril 1985 & JP 59 210729 A**
  **(HITACHI SEISAKUSHO KK), 29 novembre 1984**
- **PATENT ABSTRACTS OF JAPAN vol. 005, no.**
  **171 (E-080), 30 octobre 1981 & JP 56 098030 A**
  **(NEC CORP), 7 août 1981**
- **PATENT ABSTRACTS OF JAPAN vol. 013, no.**
  **113 (E-729), 17 mars 1989 & JP 63 283316 A**
  **(MITSUBISHI ELECTRIC CORP), 21 novembre**
  **1988**

## Description

La présente invention concerne un diviseur de fréquence à modulo variable.

Elle s'applique notamment aux réalisations de synthétiseurs de fréquence à haute pureté spectrale utilisant des diviseurs à rang variable fonctionnant à des fréquences élevées avec des modulos faibles.

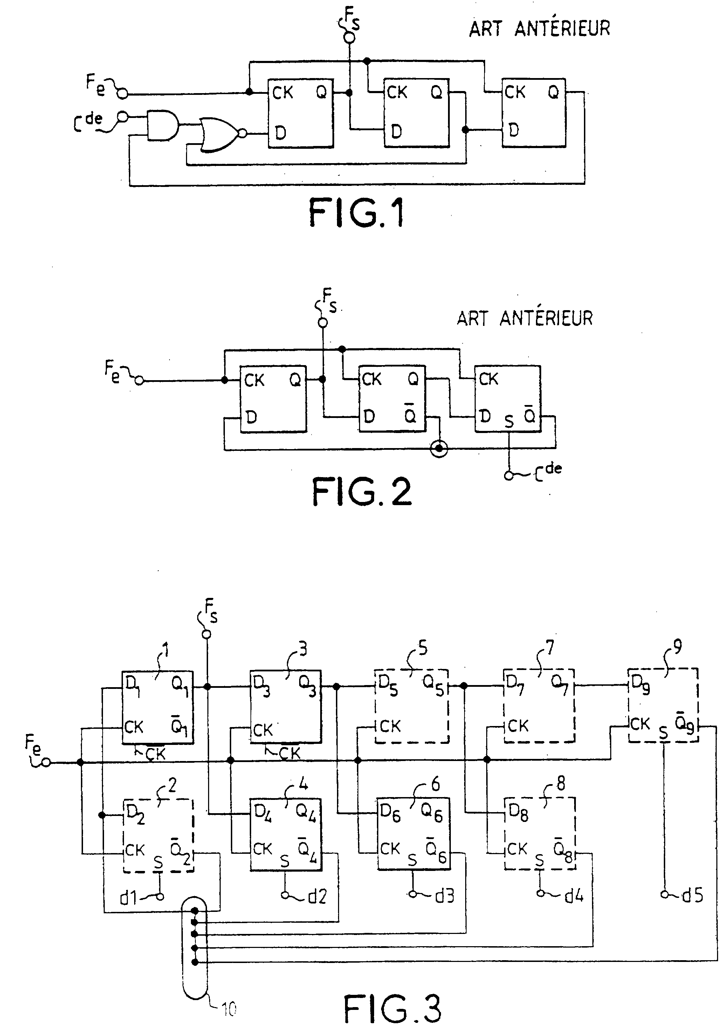

Pour réaliser des diviseurs à faibles rangs de division il est connu d'utiliser des compteurs synchrones du commerce du type par exemple de ceux commercialisés sous les références 54163 et 10136 respectivement par les sociétés de droits des Etats-Unis TEXAS INSTRUMENT et MOTOROLA ou d'utiliser des bascules reliées en cascade suivant le schéma de la figure 1 qui est celui d'un diviseur à deux modulos 4 et 5 ou encore suivant des schémas adoptés dans des circuits intégrés du type par exemple de celui qui est commercialisé sous la référence SP8680 par la société de droit anglais General Electric Company, ou encore suivant la demande de brevet JP-A-63-283316, document divulgant un diviseur de fréquence selon le préambule de la revendication 1.

Cependant les compteurs du commerce ainsi que les réalisations de diviseurs au moyen de bascules reliées en cascade présentent un fonctionnement limité dans les hautes fréquences. Ceci est principalement dû, dans les réalisations du type de celles de la figure 1, à la présence de portes logiques de rebouclage qui augmentent les temps de propagation des signaux entre les sorties des bascules et l'entrée de rebouclage de la première bascule.

D'autres types de réalisation de diviseurs du type de celle montrée à la figure 2, qui est celle d'un diviseur à deux modulos 4 et 5, mettent également en oeuvre des bascules reliées en cascade. Cependant, à la différence du modèle de la figure 1, les rebouclages ne sont pas réalisés par des portes logiques mais par un circuit "OU" câblé réalisé par de simples connexions entre des sorties de bascules et l'entrée D de la première bascule permettant de s'affranchir des temps de propagation des signaux dans les portes logiques. Ce dernier type de réalisation permet d'obtenir des fréquences de fonctionnement plus élevées que les réalisations décrites précédemment mais présente l'inconvénient d'être limité dans le nombre des rangs de division réalisables, et dans les combinaisons possibles.

A titre d'exemple, un diviseur à deux modulos 5 et 6 n'est pas réalisable par cette technique.

Le but de l'invention est de pallier les inconvénients précités en proposant une solution de diviseur utilisable pour la mise en oeuvre de synthétiseurs de fréquence capables de fournir une onde de très bonne pureté spectrale dans des bandes de fréquence élevées.

A cet effet, l'invention a pour objet un diviseur de fréquence à modulo variable du type comprenant une chaîne de bascules de type D reliées en cascade et commandées par un même signal d'horloge, la sortie Q de l'une étant reliée à l'entrée D de la suivante, et dans laquelle la sortie complémentaire $\bar{Q}$ de la dernière bascule est rebouclée sur l'entrée D de la première bascule par l'intermédiaire d'un circuit "OU", caractérisé en ce qu'il comprend une série de bascules de type D comportant un nombre déterminé de bascules associées respectivement à une bascule de la première chaîne sauf à la dernière bascule, les bascules de chaque couple ainsi formé ayant les entrées D reliées entre elles, dans laquelle les sorties complémentaires $\bar{Q}$ des bascules de la série ainsi que la sortie $\bar{Q}$ de la dernière bascule de la première chaîne sont reliées par un circuit "OU" à l'entrée D de la première bascule de la première chaîne et dans laquelle des liaisons de commande sont prévues reliant les entrées S de commande d'inhibition des bascules D de la série et de la dernière bascule D de la première chaîne pour programmer le modulo du diviseur.

L'invention a pour avantage qu'elle permet une mise en oeuvre de diviseurs rapides à modulo variable, supérieur à 3. La rapidité de fonctionnement de ces diviseurs permet d'utiliser des rangs de division faibles pour mieux garantir la pureté spectrale des synthétiseurs de fréquence.

D'autres caractéristiques et avantages de l'invention apparaîtront à l'aide de la description qui suit, faite en regard des dessins annexés qui représentent :

> Les figures 1 et 2 deux modes de réalisations de diviseurs à rang variable selon l'art antérieur.
> La figure 3 un schéma synoptique d'un mode de réalisation d'un diviseur à rang variable selon l'invention (modulo 2 à 10).
> La figure 4 la table de vérité d'une bascule de type D entrant dans la mise en oeuvre des schémas des figures 1, 2, 3, 7A à 7F.
> La figure 5 le chronogramme de la division de rang 5 mise en oeuvre suivant le schéma de la figure 3.
> La figure 6 une table de commande des rangs de division du diviseur de la figure 3.
> Les figures 7A à 7F des modes de réalisation simplifiée de diviseurs selon l'invention permettant d'obtenir des rangs de division variables par nombres entiers compris entre 2 et n ; n allant de 2 à 7.

Le diviseur selon l'invention qui est représenté à la figure 3, est plus particulièrement adapté à des réalisations en technologie ECL où les sorties Q et $\bar{Q}$ des bascules ont lieu par les émetteurs des transistors de sortie, mais il peut aussi être adapté à d'autres technologies comme la technologie TTL, par exemple, au détriment de la rapidité. Il comporte une première chaîne de bascules de type D notées respectivement 1, 3, 5, 7 et 9 reliées en cascade, la sortie Q de l'une étant reliée à l'entrée D de la suivante. La fermeture de la chaîne est réalisée en connectant la sortie $\bar{Q}$ de la dernière bascule 9 à l'entrée D de la première 1. A chaque bascule 1, 3, 5 et 7 est associée respectivement une bascule jumelle notée 2, 4, 6 et 8, les bascules de chaque couple ayant leurs entrées D reliées entre elles.

Les entrées d'horloge $C_K$ des bascules sont reliées entre elles et à l'entrée $F_e$ du diviseur.

Les sorties $\overline{Q}$ des bascules 2, 4, 6, 8 et 9 sont reliées entre elles pour former un circuit "OU" câblé 10. Elles sont rebouclées sur l'entrée D des bascules 1 et 2. Dans le cadre de réalisations en logique TTL les sorties $\overline{Q}$ doivent être reliées à une porte "OU" logique à 5 entrées.

La sortie $F_S$ du diviseur est constituée par la sortie Q de la bascule 1.

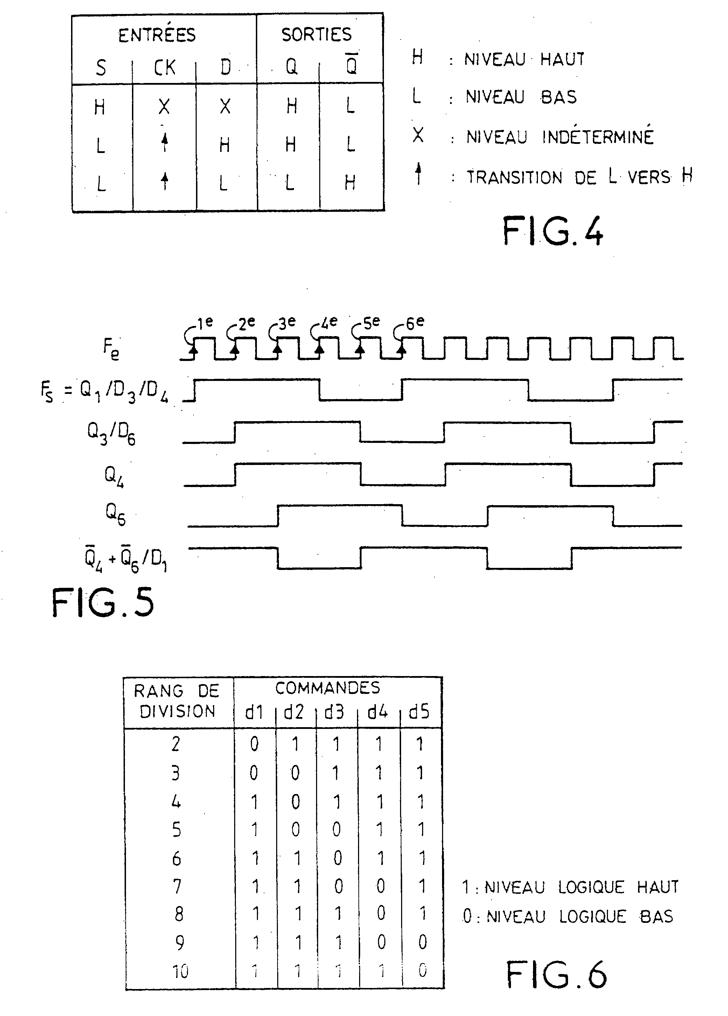

Les rangs de division sont commandés par des entrées $d_1$, $d_2$, $d_3$, $d_4$ et $d_5$ connectées respectivement sur les entrées "SET" notées S des bascules 2, 4, 6, 8 et 9. Le rang de division obtenu en fonction des commandes $d_1$ à $d_5$ est déterminé suivant la table représentée à la figure 6.

Pour la compréhension du schéma toute bascule D ayant son entrée S à 1 est inhibée et peut être ignorée. Il en est de même des bascules de numéro impair, associées aux bascules de numéro pair, comptées à partir de la dernière bascule paire dans l'ordre croissant de leur numéro de référence qui reçoit un niveau 0 sur son entrée D, exceptées la bascule 1 qu'il faut toujours conserver puisqu'elle fournit le signal de sortie, et les bascules 7 et 9 quand l'entrée S de la bascule 9 est à 0.

Ainsi dans le cas de la division par 5, les bascules 2, 8 et 9 peuvent être ignorées.

Les bascules 5 et 7 sont ignorées puisque l'entrée de commande $d_3$ est à zéro. Les bascules ignorées sont représentées en pointillés sur la figure 3.

Le chronogramme de la division par 5 ainsi réalisée est représenté à la figure 5.

Conformément au tableau de la figure 4, la sortie Q de chaque bascule prend la valeur de l'entrée D au moment ou l'entrée horloge $C_K$ passe de "0" (état bas) à "1" (état haut). Dans l'explication du fonctionnement qui suit on gardera en mémoire que les bascules sont synchrones, c'est-à-dire qu'elles sont commandées par un même signal d'horloge $F_e$ arrivant sur les entrées $C_K$. Initialement les sorties Q1, Q3, Q4 et Q6 des bascules 1, 3, 4 et 6 sont à "0"

> Q1 applique sur les entrées D3 et D4 des bascules 3 et 4 un état "0"
> Q3 applique sur l'entrée D6 de la bascule 6 un état "0"
> Le "OU" logique $\overline{Q}4 + \overline{Q}6$ applique sur l'entrée D1 de la première bascule 1 un état "1"

- Au premier front montant du signal d'horloge $F_e$:

> Q1 passe à "1", impliquant D3 et D4 à "1"
> Q3 reste à "0" impliquant D6 à "0"
> Q4 et Q6 restent à "0", $\overline{Q}4 + \overline{Q}6$ impliquant D1 à "1"

- Au deuxième front montant du signal d'horloge $F_e$

> Q1 reste à "1" impliquant D3 et D4 à "1"
> Q3 et Q4 passent à "1", Q3 impliquant D6 à "1"
> Q6 reste à "0", $\overline{Q}6$ impliquant D1 à "1"

- Au troisième front montant du signal d'horioge $F_e$

> Q1 reste à "1" impliquant D3 et D4 à "1"
> Q3 et Q4 restent à "1", Q3 impliquant D6 à "1"
> Q6 passe à 1, $\overline{Q}4 + \overline{Q}6$ impliquant D1 à "0"

- Au quatrième front montant du signal d'horloge $F_e$

> Q1 passe à "0" impliquant D3 et D4 à "0"
> Q3 et Q4 restent à "1", Q3 impliquant D6 à "1"
> Q6 reste à "1", $\overline{Q}4 + \overline{Q}6$ impliquant D1 à "0"

- Au cinquième front montant du signal d'horloge $F_e$

> Q1 reste à "0" impliquant D3 et D4 à "0"
> Q3 et Q4 retombent à "0", Q3 impliquant D6 à "0", $\overline{Q}4$ impliquant D1 à "1"
> Q6 reste à "1"

- Au sixième front montant du signal d'horloge $F_e$

> Q1 remonte à "1", impliquant D3 et D4 à "1"
> Q3 et Q4 restent à "0", Q3 impliquant D6 à "0", $\overline{Q}_4$ impliquant D1 à "1"
> Q6 retombe à "0", $\overline{Q}6$ confortant D1 à "1"

A ce stade le diviseur retrouve les mêmes états qu'après le premier front montant du signal d'horloge $F_e$ et repart pour un nouveau cycle de division identique.

Le rang de division d'un diviseur selon l'invention n'est pas limité en théorie.

D'une façon générale, il est possible, en appliquant le principe de l'invention, de réaliser n'importe quel diviseur allant d'un rang égal à 2 jusqu'à un diviseur de rang n quelconque $\geq 2$.

Si n est pair le nombre de bascules de numéro impair de la première chaîne est égal à $\frac{n}{2}$, le nombre de bascules paires de la deuxième chaîne est égal à $\frac{n-2}{2}$ et les sorties $\overline{Q}$ des bascules paires de la deuxième chaîne ainsi que de la dernière bascule de numéro impair de la première chaîne sont connectées ensemble.

Si n est impair le nombre de bascules de numéro impair de la première chaîne est égal à $\frac{n+1}{2}$, le nombre de bascules paires de la deuxième chaîne est égal à $\frac{n-3}{2}$ et les sorties $\overline{Q}$ des bascules de numéros pairs de la deuxième chaîne et des deux dernières bascules de numéros impairs de la première chaîne sont connectés ensemble.

Une autre possibilité consiste lorsque n est impair, à utiliser $\frac{n+1}{2}$ bascules impaires dans la première chaîne et $\frac{n-1}{2}$ bascules paires dans la deuxième chaîne en reliant ensemble les sorties $\overline{Q}$ des bascules paires et de la dernière bascule de numéro impair de la première chaîne.

Cette possibilité utilise une bascule de plus.

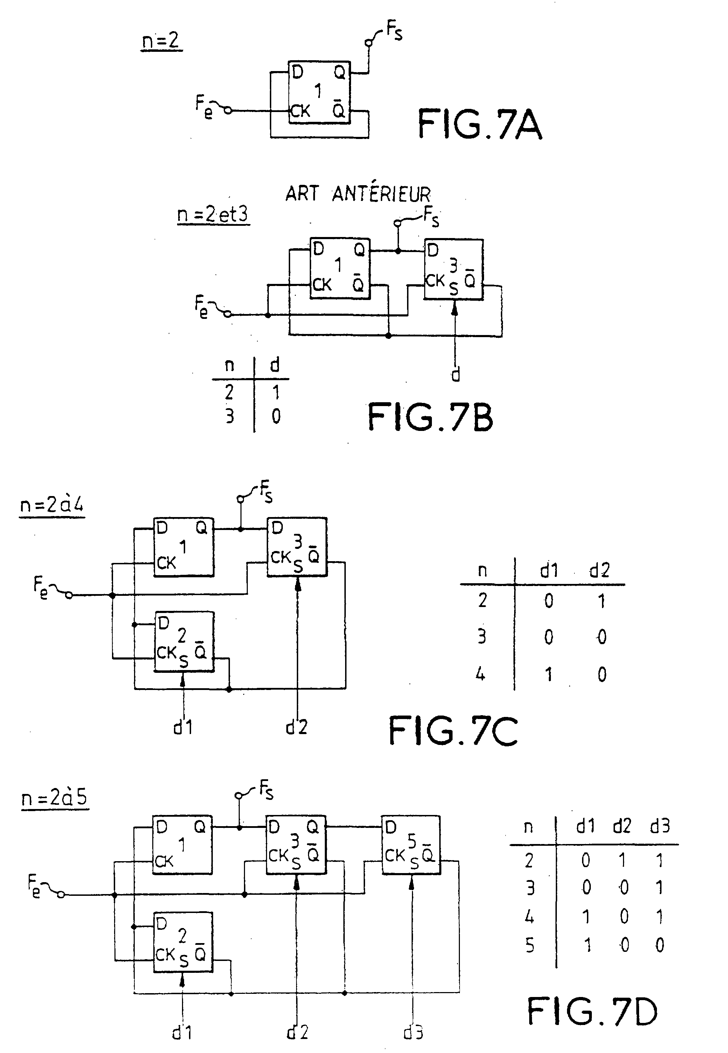

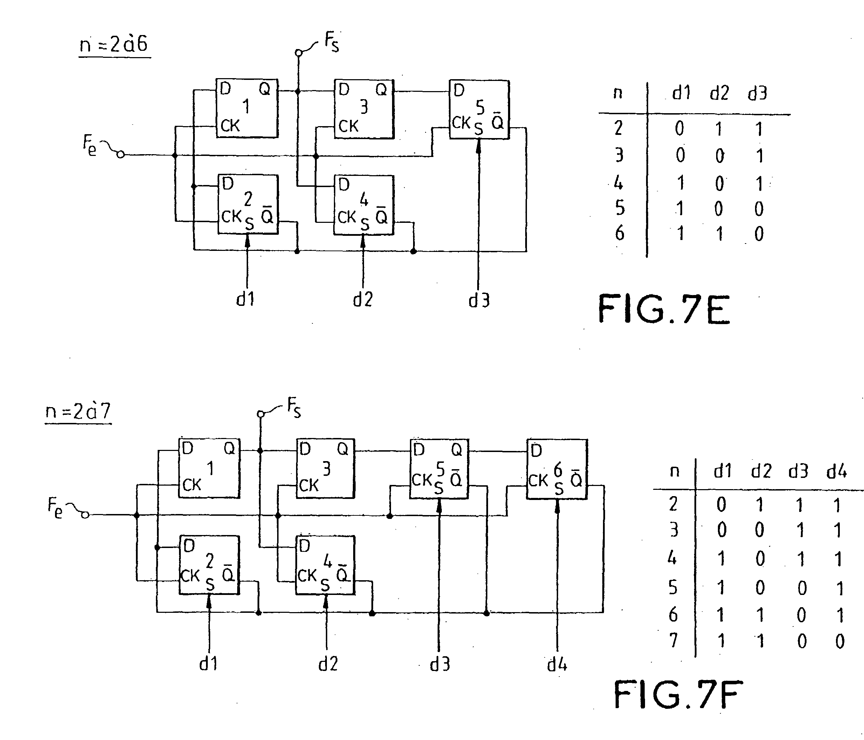

Des schémas de diviseurs selon l'invention pour des rangs de division compris entre 2 et n, (n allant de 2 à 7) avec leur tableau de commande sont représentés aux figures 7A à 7F.

## Revendications

1. Diviseur de fréquence à modulo variable du type comprenant une chaîne de bascules de type D (1, 3, 5, 7, 9) reliées en cascade et commandées par un même signal d'horloge (Fe), la sortie Q de l'une étant reliée à l'entrée D de la suivante, et dans laquelle la sortie complémentaire $\overline{Q}$ de la dernière bascule (9) est rebouclée sur l'entrée D de la première bascule (1) par l'intermédiaire d'un circuit « OU » **caractérisé en ce qu'**il comprend une série de bascules de type D (2, 4, 6, 8) comportant un nombre déterminé de bascules associées respectivement à une bascule de la première chaîne (1, 3, 5, 7) sauf à la dernière bascule (9), les bascules de chaque couple ainsi formé (1, 2; 3, 4; 5, 6; 7, 8) ayant les entrées D reliées entre elles, dans laquelle les sorties complémentaires $\overline{Q}$ des bascules de la série (2, 4, 6, 8) ainsi que la sortie $\overline{Q}$ de la dernière bascule de la première chaîne sont reliées par le circuit « OU » à l'entrée D de la première bascule de la chaîne et dans laquelle les liaisons de commande ($d_1$, $d_2$, $d_3$ ...$d_5$) sont prévues reliant les entrées S de commande d'inhibition des bascules D (2, 4, 6, 8) de la série et de la dernière bascule D (9) de la chaîne pour programmer le modulo du diviseur.

2. Diviseur selon la revendication 1, **caractérisé en ce qu'**il comprend pour réaliser une division modulo 2 à n pair, $\frac{n}{2}$ bascules dans la chaîne et $\frac{n-2}{2}$ bascules dans la série, la sortie complémentaire $\overline{Q}$ de la dernière bascule de la chaîne et les sorties complémentaires $\overline{Q}$ des bascules de la série sont reliées à l'entrée D des premières bascules de la chaîne et de la série par l'intermédiaire du circuit « OU ».

3. Diviseur selon la revendication 1 **caractérisé en ce qu'**il comprend pour réaliser une division modulo 2 à n impair, $\frac{n+1}{2}$ bascules dans la chaîne et $\frac{n-3}{2}$ bascules dans la série, les sorties complémentaires $\overline{Q}$ des deux dernières bascules de la chaîne étant reliées aux sorties $\overline{Q}$ des bascules de la série à l'entrée des premières bascules de la chaîne et de la série par l'intermédiaire du circuit « OU ».

4. Diviseur selon la revendication 1 **caractérisé en ce qu'**il comprend pour réaliser une division modulo 2 à n impair, $\frac{n+1}{2}$ bascules impaires dans la chaîne et $\frac{n-1}{2}$ bascules paires de la série en reliant ensemble les sorties $\overline{Q}$ des bascules paires et de la dernière bascule $\overline{Q}$ de numéro impair de la chaîne par l'intermédiaire du circuit « OU ».

5. Diviseur selon la revendication 1 pour réaliser une division modulo m à n, m<n, n pouvant être aussi grand qu'on veut **caractérisé en ce qu'**il comprend un nombre de bascules qui dans le diagramme de vérité du diviseur ont leurs entrées d'inhibition S toujours à zéro ou évoluant suivant les états « 0 » ou « 1 » excluant les bascules qui ont leur entrée d'inhibition S toujours à 1.

## Patentansprüche

1. Frequenzteiler mit variablem Modulwert, der eine erste Kette von n Kippstufen (1, 3, 5, 7, 9) vom Typ D mit n>3 enthält, die in Kaskade geschaltet sind und von einem gemeinsamen Taktsignal ($F_e$) gesteuert werden, wobei der Ausgang Q einer Kippstufe an den Eingang D der nächstfolgenden angeschlossen ist und der komplementäre Ausgang $\overline{Q}$ der letzten Kippstufe (9) an den Eingang D der ersten Kippstufe (1) über eine ODER-Schaltung zurückgeschleift ist, **dadurch gekennzeichnet, daß** er eine zweite Serie von Kippstufen (2, 4, 6, 8) des Typs D mit einer bestimmten Anzahl von Kippstufen enthält, die je einer Kippstufe der ersten Kette (1, 3, 5, 7) mit Ausnahme der letzten Kippstufe (9) zugeordnet sind, wobei die Eingänge D jedes so gebildeten Paars von Kippstufen (1, 2; 3, 4; 5, 6; 7, 8) miteinander verbunden sind und die komplementären Ausgänge ($\overline{Q}$) der Kippstufen der zweiten Serie (2, 4, 6, 8) sowie der Ausgang $\overline{Q}$ der letzten Kippstufe der ersten Kette über die ODER-Schaltung mit dem Eingang D der ersten Kippstufe der ersten Kette verbunden sind und wobei Steueranschlüsse ($d_1$, $d_2$, ..., $d_5$) vorgesehen sind, die an die Eingänge S zur Sperrsteuerung der Kippstufen (2, 4, 6, 8) der zweiten Serie und der letzten Kippstufe (9) der ersten Kette angeschlossen sind, um den Modulwert der Teilerschaltung zu programmieren.

2. Teilerschaltung nach Anspruch 1, **dadurch gekennzeichnet, daß** er zur Bildung eines Teilers mit Modulwerten von 2 bis zu einem geradzahligen Wert n in der ersten Kette n/2 Kippstufen und in der zweiten Serie (n-2)/2 Kippstufen enthält, wobei der komplementäre Ausgang $\overline{Q}$ der letzten Kippstufe der ersten Kette und die komplementären Ausgänge $\overline{Q}$ der Kippstufen der zweiten Serie an den Eingang D der ersten Kippstufen der Kette und der Serie über die ODER-Schaltung angeschlossen sind.

3. Teilerschaltung nach Anspruch 1, **dadurch ge-**

**kennzeichnet, daß** er zur Bildung eines Teilers mit Modulwerten von 2 bis zu einem ungeradzahligen Wert n in der ersten Kette (n+1)/2 Kippstufen und in der zweiten Serie (n-3)/2 Kippstufen enthält, wobei die komplementären Ausgänge $\bar{Q}$ der beiden letzten Kippstufen der ersten Kette und die komplementären Ausgänge $\bar{Q}$ der Kippstufen der zweiten Serie an den Eingang D der ersten Kippstufen der Kette und der Serie über die ODER-Schaltung angeschlossen sind.

4. Teilerschaltung nach Anspruch 1, **dadurch gekennzeichnet, daß** sie zur Bildung eines Teilers mit Modulwerten von 2 bis zu einem ungeradzahligen Wert n in der ersten Kette (n+1)/2 Kippstufen und in der zweiten Serie (n-1)/2 Kippstufen enthält, wobei alle Ausgänge $\bar{Q}$ der Kippstufen der Serie sowie der Ausgang $\bar{Q}$ der letzten Kippstufe der Kette über die ODER-Schaltung miteinander verbunden sind.

5. Teilerschaltung nach Anspruch 1 zur Bildung eines Teilers modulo m bis n, wobei m<n ist und n beliebig groß sein kann, **gekennzeichnet durch** eine Anzahl von Kippstufen, die in der Wahrheitstabelle des Teilers mit ihren Sperreingängen S stets den Pegel "0" empfangen oder sich gemäß den Zuständen "0" oder "1" entwickeln, mit Ausnahme der Kippstufen, deren Sperreingang stets auf "1" liegt.

**Claims**

1. Variable-modulo frequency divider of the type comprising a first chain of n greater than 3 D type flip-flops (1, 3, 5, 7, 9) linked in cascade and controlled by the same clock signal (Fe), the output Q of one being linked to the input D of the next, and in which the complementary output $\bar{Q}$ of the last flip-flop (9) is fed back to the D input of the first flip-flop (1) by way of an "OR" circuit, **characterized in that** it comprises a second series of D type flip-flops (2, 4, 6, 8) comprising a determined number of flip-flops associated respectively with a flip-flop of the first chain (1, 3, 5, 7) except with the last flip-flop (9), the flip-flops of each pair thus formed (1, 2; 3, 4; 5, 6; 7, 8) having the D inputs linked together, in which the complementary outputs $\bar{Q}$ of the flip-flops of the second series (2, 4, 6, 8) as well as the output $\bar{Q}$ of the last flip-flop of the first chain are linked by the "OR" circuit to the D input of the first flip-flop of the first chain and in which control links ($d_1$, $d_2$ ... $d_5$) are provided linking the control inputs S for disabling the D flip-flops (2, 4, 6, 8) of the second series and of the last D flip-flop (9) of the first chain so as to programme the modulo of the divider.

2. Divider according to Claim 1, **characterized in that** it comprises, for carrying out a division modulo 2 to n even, $\frac{n}{2}$ flip-flops in the first chain and $\frac{n-2}{2}$ flip-flops in the second series, the complementary output $\bar{Q}$ of the last flip-flop of the first chain and the complementary outputs $\bar{Q}$ of the flip-flops of the second series are linked to the D input of the first flip-flops of the even and odd chains by way of the "OR" circuit.

3. Divider according to Claim 1, **characterized in that** it comprises, for carrying a division modulo 2 to n odd, $\frac{n+1}{2}$ flip-flops in the first chain and $\frac{n-3}{2}$ flip-flops of the second series, the complementary outputs $\bar{Q}$ of the last two flip-flops of the first chain being linked to the outputs $\bar{Q}$ of the flip-flops of the second series to the D input of the first flip-flops of the even and odd chains by way of the "OR" circuit.

4. Divider according to Claim 1, **characterized in that** it comprises, for carrying out a division modulo 2 to n odd, $\frac{n+1}{2}$ odd flip-flops in the first chain and $\frac{n-1}{2}$ even flip-flops of the second series, by linking together the outputs $\bar{Q}$ of the even flip-flops and of the last odd-numbered flip-flop $\bar{Q}$ of the first chain by way of the "OR" circuit.

5. Divider according to Claim 1 for carrying out a division modulo m to n, m<n, n being as large as desired, **characterized by** a number of flip-flops which in the truth chart of the divider have their disable inputs S always at zero or altering according to the "0" or "1" state, excluding the flip-flops which have their disable input S always 19.

FIG.1

FIG.2

FIG.3

| ENTRÉES | | | SORTIES | |
|---|---|---|---|---|
| S | CK | D | Q | $\overline{Q}$ |
| H | X | X | H | L |
| L | ↑ | H | H | L |
| L | ↑ | L | L | H |

H : NIVEAU HAUT

L : NIVEAU BAS

X : NIVEAU INDÉTERMINÉ

↑ : TRANSITION DE L VERS H

## FIG.4

$F_e$

$F_s = Q_1/D_3/D_4$

$Q_3/D_6$

$Q_4$

$Q_6$

$\overline{Q}_4 + \overline{Q}_6/D_1$

## FIG.5

| RANG DE DIVISION | COMMANDES | | | | |
|---|---|---|---|---|---|
| | d1 | d2 | d3 | d4 | d5 |
| 2 | 0 | 1 | 1 | 1 | 1 |
| 3 | 0 | 0 | 1 | 1 | 1 |
| 4 | 1 | 0 | 1 | 1 | 1 |
| 5 | 1 | 0 | 0 | 1 | 1 |
| 6 | 1 | 1 | 0 | 1 | 1 |
| 7 | 1 | 1 | 0 | 0 | 1 |
| 8 | 1 | 1 | 1 | 0 | 1 |
| 9 | 1 | 1 | 1 | 0 | 0 |
| 10 | 1 | 1 | 1 | 1 | 0 |

1 : NIVEAU LOGIQUE HAUT

0 : NIVEAU LOGIQUE BAS

## FIG.6

n=2

FIG.7A

ART ANTÉRIEUR

n=2 et 3

| n | d |
|---|---|
| 2 | 1 |
| 3 | 0 |

FIG.7B

n=2 à 4

| n | d1 | d2 |
|---|----|----|
| 2 | 0 | 1 |
| 3 | 0 | 0 |
| 4 | 1 | 0 |

FIG.7C

n=2 à 5

| n | d1 | d2 | d3 |
|---|----|----|----|
| 2 | 0 | 1 | 1 |
| 3 | 0 | 0 | 1 |
| 4 | 1 | 0 | 1 |
| 5 | 1 | 0 | 0 |

FIG.7D

8

EP 1 020 032 B1

n = 2à6

| n | d1 | d2 | d3 |
|---|----|----|----|
| 2 | 0  | 1  | 1  |
| 3 | 0  | 0  | 1  |
| 4 | 1  | 0  | 1  |
| 5 | 1  | 0  | 0  |
| 6 | 1  | 1  | 0  |

FIG.7E

n = 2à7

| n | d1 | d2 | d3 | d4 |
|---|----|----|----|----|
| 2 | 0  | 1  | 1  | 1  |
| 3 | 0  | 0  | 1  | 1  |
| 4 | 1  | 0  | 1  | 1  |
| 5 | 1  | 0  | 0  | 1  |
| 6 | 1  | 1  | 0  | 1  |
| 7 | 1  | 1  | 0  | 0  |

FIG.7F